Europäisches Patentamt

**European Patent Office**

**Office européen des brevets**

(19)

(11) Publication number: **0 062 547**
A2

(12) **EUROPEAN PATENT APPLICATION**

(21) Application number: **82301888.2**

(22) Date of filing: **08.04.82**

(51) Int. Cl.³: **G 11 C 11/24**

(30) Priority: **08.04.81 JP 52661/81**

(43) Date of publication of application: **13.10.82**
**Bulletin 82/41**

(84) Designated Contracting States: **DE FR GB**

(71) Applicant: **NIPPON ELECTRIC COMPANY LIMITED,**
**Sumitomo Mita Building 37-8 Shiba Gochome Minato-ku,**
**Tokyo 108 (JP)**

(72) Inventor: **Kobayashi, Satoru Nippon Electric Company**
**Limited, Sumitomo Mita Building 37-8, Shiba Gochome,**
**Minato-ku Tokyo 108 (JP)**

(74) Representative: **Pritchard, Colin Hubert et al, Mathys &**
**Squire 10 Fleet Street, London EC4Y 1AY (GB)**

(54) **Memory circuit.**

(57)     A memory circuit which can perform consecutive write operations at a high speed is disclosed. The memory circuit comprises a plurality of bus lines, a plurality of memory cell groups associated to the respective bus lines, a plurality of latch circuits coupled to the respective bus lines, and means for sequentially supplying the bus lines with write data, in which the write data are stored in the latch circuits and transferred to selected memory cells of the respective memory cell groups.

0062547

# MEMORY CIRCUIT

The present invention relates to a memory circuit, and more particularly a semiconductor memory circuit employing MIS transistors.

In a semiconductor memory making use of MIS transistors, memory capacity has been steadily increasing owing to the progress of the integration technique in the recent years and memory devices having 64 K bit capacity have been made commerciably available. While, owing to the progress of the circuit technique, a number of pins in a package has been decreased and a mount density of memory devices has been increased by multiple-addressing technique detailed in United States Patent No. 3,969,706 in which row address signals and column address signals are incorporated through the same set of address terminals in response to a row address strobe signal ($\overline{RAS}$) and to a column address strobe signal ($\overline{CAS}$), respectively. However, according to the multiple-addressing technique, each operation of the memory requires the activation of the row address strobe signal and the activation of the column strobe signal, and hence operation speed of this type memory has been limited. In this respect, the inventor of the present invention already proposed a novel memory by the Japanese Patent Application No. 100850/1980 which was field to the United State Patent and Trademark Office as Serial No. 286,378 and to the European Patent Office as Serial No. 81105827.0 with the priority.

According to this prior application, the memory circuit is a MOS · random access memory (hereinafter abbreviated as RAM) formed by providing a plurality of input/output (I/O) bus pairs and a decoder circuit associated with a shift register for enabling the I/O bus pairs to access to consecutive address along the column direction in the heretofore known RAM of the multiple-addressing system employing a Row Address Strobe clock ($\overline{\text{RAS}}$) and Column Address Strobe clock ($\overline{\text{CAS}}$), in which initially any arbitrary address information is taken in upon the normal RAS/CAS cycle. When the memory cell has been accessed, at the same time column address information is taken in the shift register. Thereafter, when the operation transfers to a "consecutive access mode" which is controlled only by the $\overline{\text{CAS}}$ clock while maintaining the $\overline{\text{RAS}}$ clock at its active level, memory cells having consecutive addresses along the column direction which are determined on the basis of the column address information taken in during the RAS/CAS cycle just before the transfer to the consecutive access cycle, are accessed bit by bit each time the $\overline{\text{CAS}}$ clock comes in as controlled by a shift clock generated in synchronism with the consecutive access mode. Therefore, access can be done without necessitating the column address information which was taken in by a column address buffer and thus obtained in the prior art, so that the operation time necessitated therefor can be perfectly omitted.

In connection to the access time in the above-described operation mode, in addition to not necessitating the above-mentioned column address information, the memory cell information has been already transmitted to a plurality of I/O bus pairs in an amplified state, so that an I/O bus pair is selected by an internal clock which is generated immediately at the falling edge of the $\overline{CAS}$ clock, and

only a data buffer amplifier associating with the I/O bus pair is activated by a clock generated subsequently in response to the internal clock, and it can transmit cell information to an output terminal.   Accordingly, a remarkable effect can be achieved such that high speed access which has not realized in the page mode in the prior art, can be achieved.

As described above, the access time in this consecutive mode is as very short as 30 NS or less, the cycle time including the reset time

of the $\overline{CAS}$ is also as very short as 70 NS or less, and thus a memory circuit that is operable at a high speed cycle can be realized.   However, during a write cycle in the consecutive access mode, the operations of taking input information into a data input buffer, producing data binary codes, transferring data to a memory cell, etc. must be completed within the activation period of the $\overline{CAS}$, but it is difinitely impossible to perfectly finish these various operations within the very short period of 30 NS or less.   Hence, it is compelled to increase the $\overline{CAS}$ activation

period by about 20 NS.   This results in a large difference between the read cycle time and the write cycle time, and there may possibly occur disadvantages such as difficulty in control for generation of an external drive clock and degradation of a performance upon introducing the RAM into a system.

It is one object of the present invention to provide a memory circuit which can perform consecutive write operations at a high speed.

According to one aspect of the present invention, there is provided a memory circuit comprising a plurality of memory cells arranged in a matrix of rows and columns, a first number of bus lines, row means for selecting one of the rows, a first column decoder for selecting a first number of the columns to be connected to the first number of the bus lines, a data line, a plurality of switching means coupled between the data line and the bus lines, a second column decoder for selecting one of the switching means, and a plurality of data registers provided for the respective data lines for operatively storing data on the associated bus line.

According to another aspect of the present invention, there is also provided a memory circuit comprising a plurality of bus lines, a plurality of memory cell groups provided in correspondence to the respective one of the bus lines, a data line, a plurality of transfer gates coupled between the respective bus lines and the data line, means for supplying the data line with write data, a plurality of latch circuits coupled to the respective bus lines, and means for sequentially enabling the transfer gates, in which write data are sequentially stored in the latch circuits through the enabled transfer gates and the stored write data are written into the memory cells associated to the respective bus line.

According to still another aspect of the present invention, there is also provided a memory device comprising a monolithic semiconductor chip; a matrix of memory cells arrayed in rows and columns, a memory cell in each column being connected to a corresponding column line in response to a voltage on a row address line and data being transferred to and from each cell in each column from and to the corresponding column line; sense amplifier means for the respective column lines for discriminating between at least two voltage levels representative of logic states and holding the detected logic state; a row address strobe input for inputting a row address strobe to the chip; row address decode means responsive to a row address strobe input to the chip for decoding row address data and holding the addressed row of memory cells enabled until the termination of the row address cycle; a column address strobe input for inputting a column address strobe signal to the chip; column address means for incorporating column address data in response to said column address strobe signal; column address decoder means; shift register means arranged in parallel with said column address decoder means; control means for operatively enabling said shift register means upon each reception of said column strobe signal during the same row address cycle; a data line, at least one latch circuit for storing data supplied through the data line means responsive to the shift register for enabling the transfer of the stored data to the column identified by the shift register.

Fig. 1 is a diagram for explaining memory cell read/write operations in a MOS semiconductor RAM having an I/O bus pair in the prior art,

Fig. 2 is a timing waveform diagram showing a consecutive access mode according to the proposed memory by the invention;

Fig. 3 is a diagram showing a basic construction according to the present invention;

Fig. 4 is a timing diagram for the basic construction, and

Fig. 5 is a diagram showing one preferred embodiment of the present invention.

In the following, description will be made with reference to the accompanying drawings.

Though the explanation will be given by use of N-channel MOS field effect transistors and positive logic system in which a high level corresponds to a logic "1" level while a low level corresponds to a logic "0" level, it should be apparent that the present invention can be realized by use of P-channel field effect transistors and/or a negative logic system.

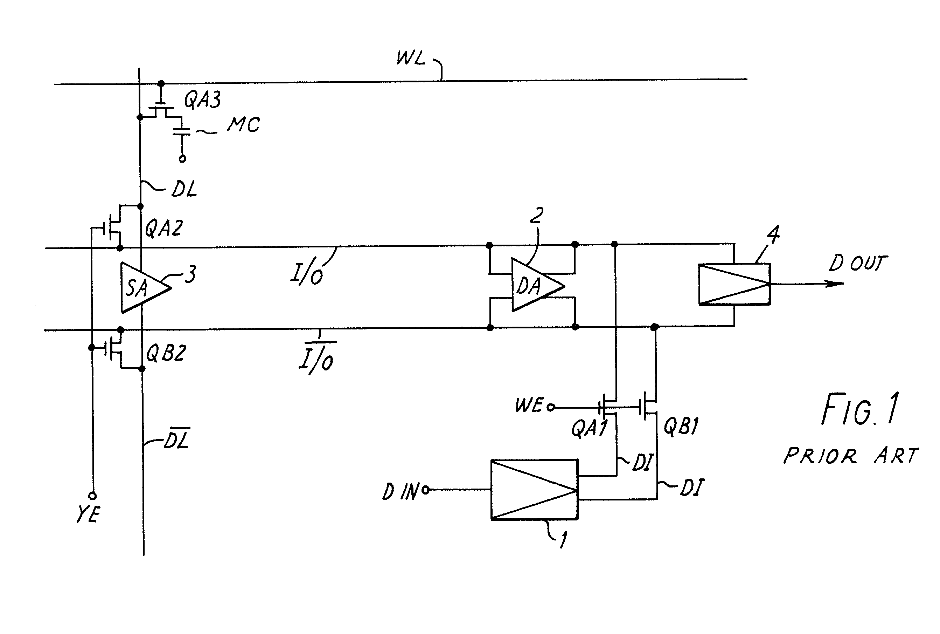

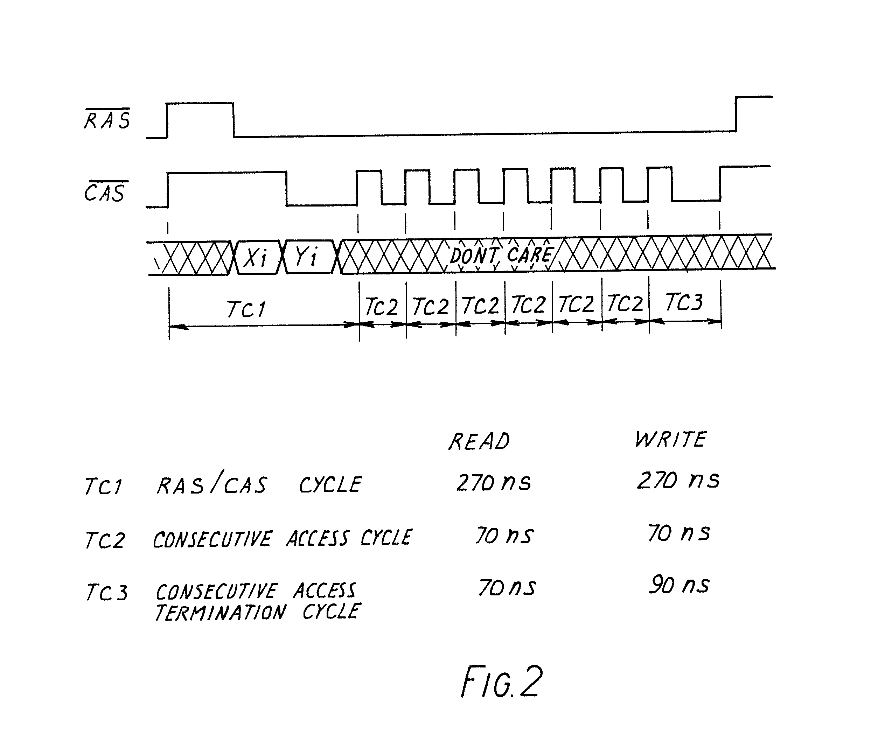

First, with reference to Figs. 1 and 2, a RAM according to the prior art will be described.

A major part employed for a write operation of the conventional RAM is shown in Fig. 1. In Fig. 1, input information upon a write cycle is first taken in a data input buffer 1 as controlled by a plurality of internal write control signals (not shown) generated in response to activation of an external write control signal (hereinafter called $\overline{WE}$ clock). Thereafter, it is amplified, transformed into data binary codes and transmitted to an I/O bus pair including bus lines I/O and $\overline{I/O}$ via transfer gate transistors $Q_{A1}$ and $Q_{B1}$, respectively, which are controlled by an internal write control signal WE. The input information transmitted to the I/O bus pair is transmitted to a pair of digit lines DL and $\overline{DL}$ through a pair of transfer gate transistors $Q_{A2}$ and $Q_{B2}$, respectively, which have been already selected upon a write cycle by an activated digit line selection signal YE and couple the I/O bus pair in an active state and the digit lines DL and $\overline{DL}$ to each other. Further, it is transmitted to a memory cell MC via a transfer gate transistor $Q_{A3}$ which is controlled by a selected word line WL.

With regard to the time required until this input information has been written in a memory cell, in the case of the conventional MOS logic "1" level write, especially in the case where the logic "1" level is written after memory cell information at the logic "0" level has been read out which is believed to be the worst case, if one consider the time necessitated for the write potential to a memory cell to rise from the "0" level to the logic "1" level sufficient for assuming an operation margin of the circuit, a period of 20 nanosecond (NS) ~ 30 NS would be spent. Hence in the case where this margin is introduced to a RAM operable in a consecutive access mode, the write cycle time in the consecutive access mode would necessitate an excessive write level assuming period of at least 20 NS, and hence, a large difference will be produced between the read cycle time and the write cycle time, resulting in a disadvantage that in the case of introducing the RAM in a memory system or the like, a performance thereof is degraded.

Now, the "consecutive access mode" will be explained briefly with reference to timing waveforms in Fig. 2. During a RAS/CAS cycle of a period $T_{C1}$, in response to transistion of the $\overline{RAS}$ clock from the logic "1" level to the logic "0" level, row address information ($Xi$) is taken in, and their memory cells coupled to the word line designated by the row address information are accessed. Thereafter the $\overline{CAS}$ clock transfers from the logic "1" level to the "0" level and thereby column address information ($Yi$) is taken in. Subsequently, memory cell information amplified by a sense amplifier designated by the column address information is transmitted to the I/O bus pair, and transmitted to a data output terminal $D_{OUT}$ as controlled by a plurality of internal activation clocks which occur in succession. The row address information is taken in a shift register (not shown) as controlled by a holding clock that is generated in synchronism with the signal for controlling the transfer gate transistors ($Q_{A2}$ and $Q_{B2}$) which couple the memory cell information amplified by the sense amplifier to the I/O bus lines. The shift register has latch and reset functions for the address information in response to single holding clock, and so long as the RAS/CAS cycles continue, hold and refresh are effected.    Thereafter, if the operation transfers to a consecutive access mode ($T_{C2}$) in which only the $\overline{CAS}$ clock changes its level while maintaining the $\overline{RAS}$ in an activated state. Then feed of the column address information upon every activation of the $\overline{CAS}$ clock as in the case of the page mode in the prior art is not necessitated, but on the basis of the column address information taken in the RAS/CAS cycle just prior to the consecutive access mode, the shift register starts transfer of the decoded information for each one bit, hence the decoders would be consecutively selected, and thus the time required for the latch operation of the column address information by means of a column address buffer and for the operation of the decoders by means of the subsequently amplified and produced address binary codes, can be omitted.    Furthermore, in the above-mentioned mode, since the memory information accessed in the RAS/CAS cycle immediately before the above-mentioned consecutive access mode has been already amplified and transmitted to a plurality of I/O bus pairs, a selected I/O bus drive signal is produced by the activation clock which is generated immediately as synchronized with the falling edge of the $\overline{CAS}$, and the cell information can be transmitted to an output terminal by merely selecting the I/O bus drive signal, coupling it to a data I/O bus pair and driving the output buffer associated therewith.    Accordingly, not only a remarkable effect can be expected that an access time of 30 NS or less which is 1/2 ~ 1/3 or less of the access time in the page mode in the prior art, can suffice, but also the time required for reset of the $\overline{CAS}$ in the consecutive access mode may consist of only the precharge time of the data I/O bus and the data buffer, and therefore, a remarkable effect can be realized in shortening the cycle time.   As for representative rated values in a representative 16K RAM and further a 64K RAM of the RAS / CAS 2-clock operation type in the prior art, as compared to the RAS / CAS cycle time of 270 NS which is represented by $T_{C1}$ in Fig. 2, the consecutive access time represented by $T_{C2}$ can be shortened to 70 NS which is shorter than 1/4 of the former.

The above-mentioned is the operation and characteristics of the high speed read cycle in the consecutive access mode, and the writing cycle in that mode is as follows.   For the writing operation during the normal RAS / CAS cycle ($T_{C1}$), two modes are known, which include a READ-MODIFY-WRITE cycle in which after memory cell information has been read, data is written, and an EARLY-WRITE cycle in which before memory cell information appears at a data output terminal the output terminal is held at a high impedance state condition as controlled by an internal signal activated by the $\overline{WE}$ clock.   In the following description the latter mode will be employed because it is intended to refer to only the case of high speed writing.   That is, in the "EARLY-WRITE cycle", when the $\overline{CAS}$ and $\overline{WE}$ clocks shift from the "1" level to the "0" level and thus take activated conditions, in response to an activation clock that is generated immediately in synchronism with the $\overline{WE}$ clock, input information is taken in the data

0062547

input buffer and amplified, and thereby binary data code is produced. The clock taking charge of amplification of the input information by means of the data input buffer achieves drive of a control signal for the transfer gate transistors which couple the binary data codes to the I/O bus pair, and thereby quickly effects writing of the input information in the memory cell. However, considering the necessary time for reading and writing, respectively, in this consecutive access mode, in reading what determines the access time is, as described previously, two clocks: the I/O bus selection drive clock and the output buffer activation clock which is preset so as to be produced in response to the former clock. Whereas, in a write cycle, first, input information to be written must be taken in the data input buffer in response to a clock generated immediately after activation by the $\overline{CAS}$, and in response thereto it is necessary to amplify the information taken in the input buffer, produce binary data codes and at the same time produce a drive signal for data transfer to the selected I/O bus pair. The increment of about 20 NS of the write cycle in the consecutive access mode, which is increased in view of the fact that increase of a necessary time by about 20 NS is essentially necessary if consideration is made on the time necessitated for the potential rise of the memory cell that is caused via two transistors including the transistor for coupling the I/O bus line to the digit line and the transistor for coupling the digit line to the memory cell by the information transferred to the I/O bus pair, amounts to increase of about 30% with respect to the read cycle time. Hence, the loss is extremely large.

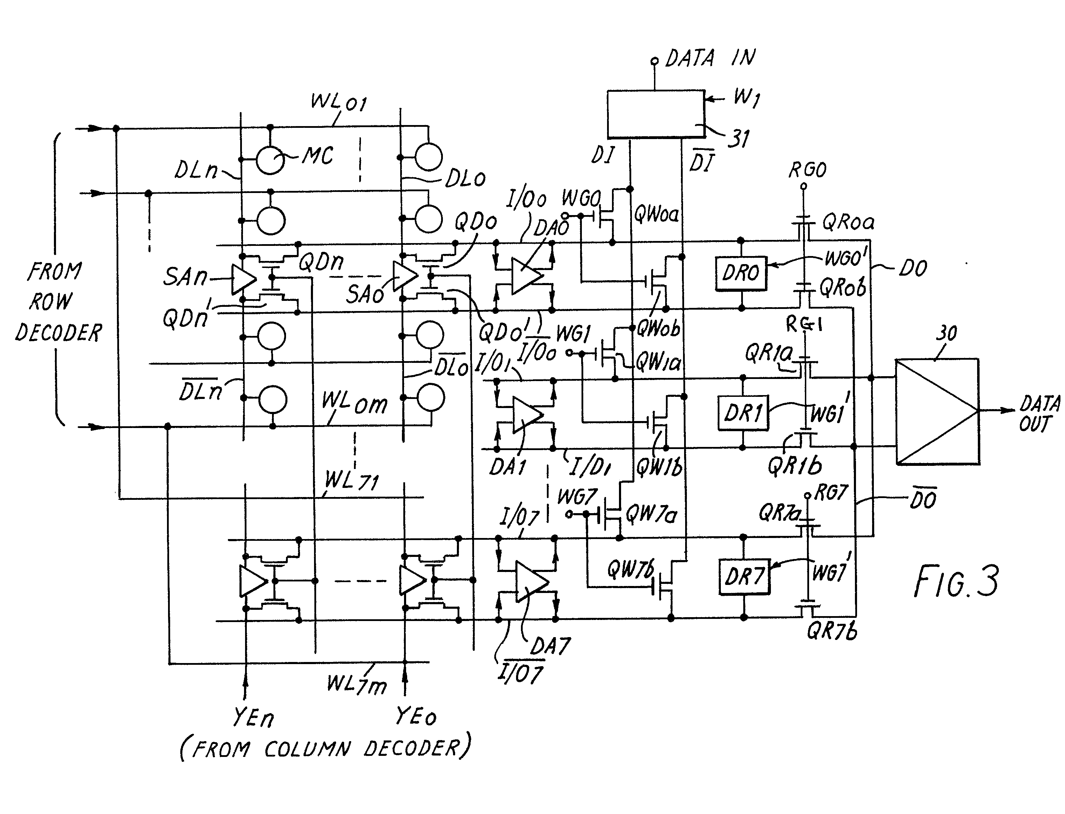

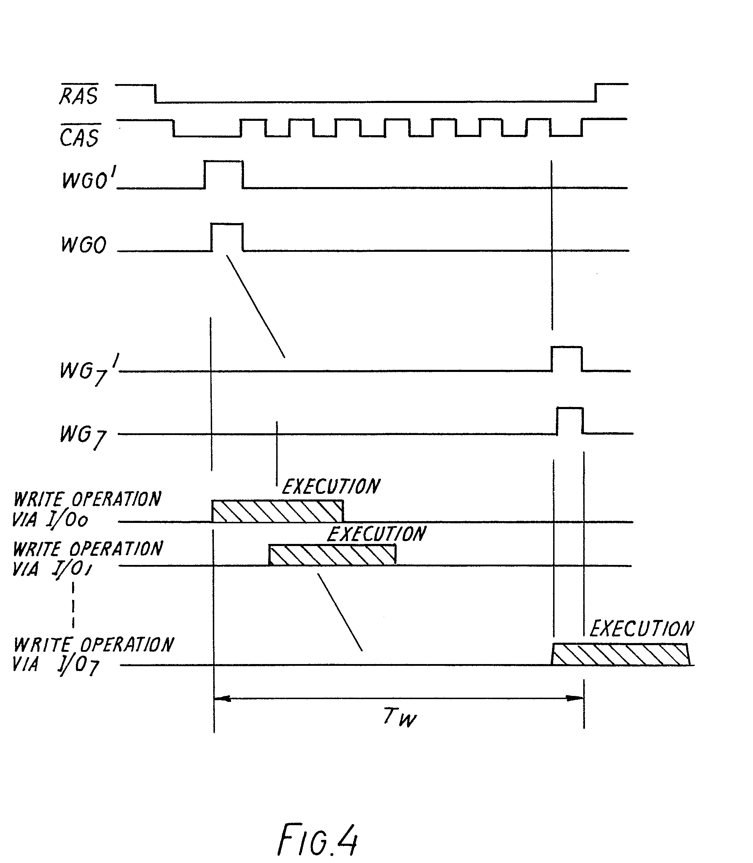

Now, the preferred embodiment of the present invention will be described with reference to Figs. 3 and 4.

In Fig. 3, eight pairs of I/O bus lines ($I/O_0$, $\overline{I/O_0}$) to ($I/O_7$, $\overline{I/O_7}$) are included. To the bus line pair ($I/O_0$, $\overline{I/O_0}$), a plural pairs of digit lines ($DL_0$, $\overline{DL_0}$) to ($DL_n$, $\overline{DL_n}$) are coupled through transfer gate pairs ($QD_0$, $\overline{Q_{D'0}}$) to ($Q_{Dn}$, $\overline{Q_{Dn'}}$), respectively under control of digit selection signal $YE_0$ to $YE_n$. Memory cells are arranged at the intersections of the digit lines and word lines WL. Sense amplifiers $SA_0$ to $SA_n$ are provided for the digit line pairs ($DL_0$, $\overline{DL_0}$) to ($DL_n$, $\overline{DL_n}$), respectively in a known manner. To other bus line pairs ($I/O_1$, $\overline{I/O_1}$) to ($I/O_7$, $\overline{I/O_7}$), the same number of digit line pairs are coupled through the transfer gate pairs as the structure with respect to the bus line pair ($I/O_0$, $\overline{I/O_0}$). In this arrangement, the digit selection signals $YE_0$ to $YE_n$ are commonly utilized for designating digit line pair as to the respective bus line pairs. Data amplifiers $DA_0$ to $DA_7$ are provided for the bus line pairs ($I/O_0$, $\overline{I/O_0}$) to ($I/O_7$, $\overline{I/O_7}$), respectively and operatively amplify the signals at the their associated bus line pairs. Further, according to the present invention, data registers $DR_0$ to $DR_7$ are provide for the bus line pairs ($I/O_0$, $\overline{I/O_0}$) to ($I/O_7$, $\overline{I/O_7}$) respectively. The data registers DR 0 to $DR_7$ operatively hold the data on their associated bus line pairs respectively. A pair of data input bus lines DI and $\overline{DI}$

are coupled to the bus lines of the bus line pairs $(I/O_0, \overline{I/O_0})$ to $(I/O_7, \overline{I/O_7})$ through a plural pairs of transfer gate transistors $(QW_{0a}, QW_{0b})$ to $(QW_{7a}, QW_{7b})$, respectively. An output buffer 30 has a pair of input terminals coupled to the bus line pairs $(I/O_0, \overline{I/O_0})$ to $(I/O_7, \overline{I/O_7})$ through a pair of data lines $D_0$ and $\overline{D_0}$ and plural pairs of read gate transistors $(QR_{0a}, QR_{0b})$ to $(QR_{7a}, QR_{7b})$, respectively.

Let us now consider the cycles, in which the I/O bus pair $(I/O_0, \overline{I/O_0})$ is selected in the RAS/CAS cycle and in the subsequent consecutive access cycle the I/O buses $(I/O_1, \overline{I/O_1})$ to $(I/O_7, \overline{I/O_7})$ are sequentially selected. During the RAS/CAS cycle, if it turns to a write mode in response to activation of the $\overline{WE}$ clock, then a first write control signal is generated immediately as synchronized with the $\overline{WE}$ clock and input information is taken in the data input buffer 31. In response to a second write control signal that is generated consecutively, amplified binary data codes are produced on the data bus lines (DI, $\overline{DI}$) and coupled to the I/O bus pair via transfer gate transistors $(QW_{0a}, QW_{0b})$ to $(QW_{7a}, QW_{7b})$ for sole write use. The transfer gate transistors for sole write use are provided for the respective I/O bus pairs, and they are controlled by write gate control signals WGi (i = 0 ~ 7) so as to feed the binary data codes received from the data input buffer 31 to the selected I/O bus pair. Simultaneously with the transfer of the binary data codes to the selected I/O bus pair, the data binary information is held in the data register $DR_0$. Then,

the write operation to the memory cell associated to the I/O bus line pair ($I/O_0$, $\overline{I/O_0}$) is performed by use of the held data in the data register $DR_0$. Then, the cycle enters to the consecutive access mode by repeating the activation and the reset states of the $\overline{CAS}$ while maintaining the $\overline{RAS}$ at its active (low) level. When the $\overline{RAS}$ changes from its inactive level (high level) to its active (low) level following the occurrence of the write gate control signal $WG_0$, the first write signal $W_1$ is produced so that new write data is set in the data buffer 31 and) set write data are transferred to the I/O bus line pair ($I/O_1$, $\overline{I/O_1}$) through the transfer gate transistors $QW_{1a}$ and $QW_{1b}$ in response to a write gate control signal $WG1$. The transferred write data to the bus line pair ($I/O_1$, $\overline{I/O_1}$) are then held by the data register $DR_1$. The write operation to the memory cell associated the I/O bus line pair ($I/O_1$, $\overline{I/O_1}$) is maintained by the held data in the data register $DR_1$ after the signal $WG_1$ is turned to its inactive (low) level. In this write operation, the held data by the data register $DR_1$ are transferred to the digit line pair through the selected transfer gate transistors ($QDi$, $\overline{QDi}$). In this connection, the data amplifier $DA1$ and the sense amplifier are enabled for assuring levels for the write operation.

Thus, the write data for the memory cells associated to the bus line pairs ($1/O_2$, $\overline{I/O_2}$) to ($I/O_7$, $\overline{I/O_7}$) are sequentially stored in the data registers $DR2$ to $DR7$ respectively in response to the write gate control signals $WG7$ to $WG7$ in synchronism the respective

activation of the $\overline{CAS}$.   Thus, the respective write operations to the different memory cells can be performed in parallel by use of the stored write data.   As viewed from the external, all the write operations can be equivalently observed as if they are completed in a period TW from the occurrence of the signal WG0 to the occurrence

of the signal WG7.

Thus, the consecutive write operations can be performed at a high speed.

In this embodiment, when the operation transferred to a consecutive access cycle, shift of the decoder was effected sequentially bit by bit, upon every shift the data binary information was stored in each data register and the above operation has been completed within 8 bits, by merely elongating the activation time of the $\overline{CAS}$ by about

20 NS as compared to the preceding cycle in the last write cycle when the consecutive access cycle terminates, it becomes possible to make the input information stored in the respective data register to be transmitted as a whole to the respective I/O bus pairs simultaneously as controlled by the third write control clock generated in synchronism

with the $\overline{WE}$ clock and thereby assume the write potential at the memory cell.   Furthermore, another additional advantage is also produced in that since the respective data registers DR0 to DR7 are controlled by

decoded control signal WG0' to WG7' by the decoder, and operate to achieve selective storage, it is also possible to realize a read/write mixed mode in the consecutive access cycle.

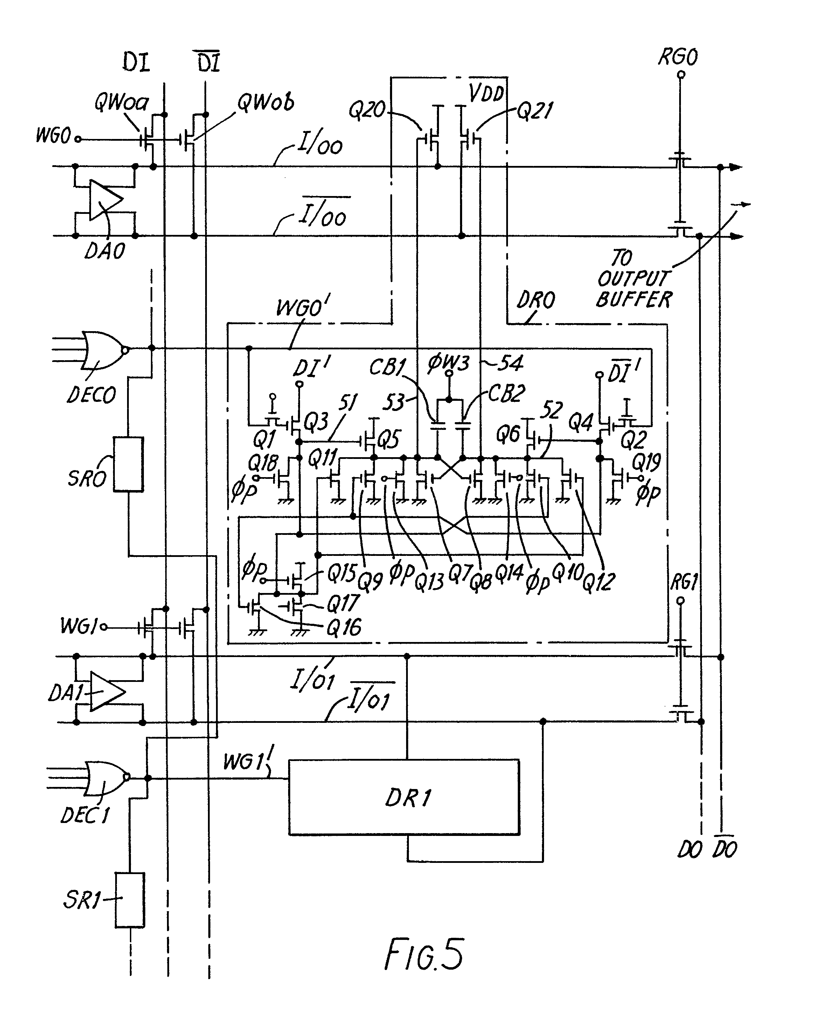

Next, the explanation will be made on a detailed example of the structure related to the data registers with reference to Fig. 5. It is now assumed that the operation transferred to the consecutive access mode of a write cycle and the output WG0' of a decoder $DEC_0$ has been selected. In addition, in order to consider high speed writing, let us consider the operation in the "EARLY-WRITE mode".

As soon as the $\overline{CAS}$ clock comes in, a signal $RG_0$ rises in response to an I/O bus pair selection drive signal which also serves as a decoded information holding signal applied to shift registers SRi (i = 0 ~ 7), an I/O bus pair $I/O_0$, $\overline{I/O_0}$ is selected. In this instance, this I/O bus pair and a data output bus pair (DO, $\overline{DO}$) are coupled to each other. At this moment, the output buffer (30) to which the above-mentioned data output bus pair enters is subjected to control by a plurality of write control signals produced in response to the $\overline{WE}$ clock and is set to inhibit its activation operation, so that an output terminal is maintained in a high impedance state. In the so-called "EARLY-WRITE mode" in which the $\overline{WE}$ clock comes in almost simultaneously with the $\overline{CAS}$ clock, in response to these clocks a first write control signal is generated immediately, thereby input information is taken in a data input buffer (not shown), the taken input information is amplified as controlled by a second write control signal which is generated subsequently, and binary data codes on the lines DI and $\overline{DI}$. The data input buffer is set so as to simultaneously produce other binary data codes (DI', $\overline{DI'}$), too.

The produced two sets of binary data codes (DI, $\overline{DI}$) and (DI', $\overline{DI'}$) are preset to take the power supply level and the ground level, respectively, when the data input buffer is in an inactivated condition. Simultaneously with production of two sets of input binary data codes, a signal $WG_0$ rises in response to the state of the output mode NG0' of the selection decoder $DEC_0$ and as driven by a second write control signal. At this moment, since either one of the data binary codes DI and DI is at the power supply level, the signal $WG_0$ is set to be higher than the power supply level for the purpose of enhancing an information transmission capability to the selected I/O bus pair. Assuming now that the memory cell information is at the "0" level, and the write information is at the "1" level, then in the selected I/O bus pair the bus $I/O_0$ takes the "0" level while the bus $\overline{I/O_0}$ takes the "1" level, and the binary data code DI is at the "1" level while the binary data code $\overline{DI}$ is at the "0" level, so that in response to the rise of the signal $WG_0$, the levels of the selected I/O bus pair are subjected to changes such that the bus $I/O_0$ tends to transfer to the "1" level while the bus $\overline{I/O_0}$ tends to transfer to the "0" level. The time required for these changes is determined depending upon how quickly the transistors (not shown) forming an output stage of the data input buffer and a pair of write control transfer gate transistors $QW_{0a}$ and $QW_{0b}$ can charge or discharge the stray capacity associated with the selected I/O bus pair $I/O_0$ and $\overline{I/O_0}$. Moreover, in response to the potential change on this I/O bus pair, charging is completed from the I/O bus pair to the selected digit line, and further from the selected digit line via the gate transistor of the cell to the memory storage node.

Next, details explanation on the data register DR0 will be provided.

When it becomes the RAS/CAS cycle in which the $\overline{\text{RAS}}$ clock is activated and the $\overline{\text{CAS}}$ clock is subsequently activated, at first a precharge clock $\phi_p$ transfers from the internal MOS logic "1" level to the "0" level. Nodes 51 ~ 54 are reset to the ground potential by transistors $Q_{13}$, $Q_{14}$, $Q_{18}$ and $Q_{19}$ which are controlled by the clock $\phi_p$, and a node 55 is charged via a transistor $Q_{15}$ up to the $V_{DD} - V_T$ level. When it becomes a write mode, the input information taken in the input data buffer as controlled by the second write control clock generated in response to the $\overline{\text{WE}}$ clock, is amplified, and if the input write information is assumed to be "1", the data binary code $\overline{\text{DI}}'$ is maintained at the ground potential. Since the relation decoder $DEC_0$ has been already selected, in response to the state of the $WG_{01}$, a transistor $Q_3$ is turned ON via a transistor $Q_1$ to follow the potential rise of the binary data code DI', hence potential rise is effected quickly, and a node 51 can rise up to the power supply level ($V_{DD}$) similarly to the binary data code DI' owing to a boot-strap effect produced by the gate-source parasitic capacitance of the transistor $Q_3$. At this moment, since the binary data code $\overline{\text{DI}}'$ is at the ground potential, a node 52 is maintained at the "0" level by a transistor $Q_4$

which has been turned ON. Furthermore, in response to the states of the nodes 51 and 52, a transistor $Q_5$ is turned ON while a transistor $Q_6$ is turned OFF. Thus, information storage nodes 53 and 54 are respectively driven to the logic "1" level which is equal to the (power supply voltage - threshold voltage) and the logic "0" level which is equal to the ground potential. At this moments the node 54 takes the so-called "0" floating potential because after resetting to the ground potential in response to the precharge clock $\phi_p$, the transistor $Q_6$ is also turned OFF, and there occurs a condition where the node 54 is liable to be influenced by an external noise or the like, hence contrivance is made such that a flip-flop consisting of transistors $Q_7$ and $Q_8$ is introduced, a transistor $Q_8$ may be turned ON in response to the "1" level at the node 53 and thereby the node 54 may be surely maintained at the ground potential.

In the RAS/CAS cycle, since a sufficiently long activation time of the $\overline{CAS}$ can be obtained, generation of a third write control signal $\phi_{W3}$ in response to the $\overline{WE}$ clock becomes possible, and in response to the rise of that clock, owing to the existence of capacitors $CB_1$ and $CB_2$, the potentials at the nodes 53 and 54 are boosted. At this moment, since the node 53 is at the "1" level, further potential rise is effected, and in view of the fact that the potential before boosting is at least as high as the $V_{DD}-V_T$ level in the RAS/CAS cycle, the node 53 can be raised in potential higher than the power supply level by means of the capacitor $CB_1$ which is preset at an appropriate capacitance value. On the other hand, the node 54 is at the ground potential, and charging of a stray capacitance at the node 54 is effected through the capacitor $CB_2$ by the clock $\phi_{W3}$, hence slight potential rise is observed, but due to the existence of the transistor $Q_8$, the charged electric charge is quickly discharged. Since the node 53 is bosted higher than the power supply level, thereby a transistor $Q_{20}$ is turned ON and thus the input information "1" is written in a memory cell, a novel function which was not present in the prior art can be provided in that only one I/O bus $I/O_0$ in the selected I/O bus pair has its potential rise accelerated by the clock $\phi_{W3}$ on the basis of the information stored in this data register.

The above-described basic operation is applicable also to a consecutive access cycle. In either cycle, generation of a write control clock in response to application of the $\overline{WE}$ clock is possible, and the only difference exists in whether generation of the third write control clock $\phi_{W3}$ is present or not depending upon whether the activation time of the $\overline{CAS}$ is large or small, temporary storage of the input information at the data storage nodes 53 and 54 is always effected, and in the activation time of the $\overline{CAS}$ of 30 NS, though a sufficiently high level cannot be written in the memory cell, the information storage in the data registers selected for the respective cycles is always possible. OR-coupled transistors $Q_{16}$ and $Q_{17}$ which are subjected to control by the nodes 52 and 51, respectively, from an NOR logic jointly with a load transistor $Q_{15}$ which is subjected

to control by the clock $\phi_p$, and a NOR output node 35 controls transistors $Q_{11}$ and $Q_{12}$ which reset the information storage nodes 53 and 54 to the ground potential. Thereby the node 55 is maintained at a high level until the data register is selected to operate, and measures are taken such that potential rise at the storage nodes 53 and 54 caused by generation of the clock $\phi_{W3}$ may be suppressed and erroneous writing to an unselected I/O bus pair and an I/O bus pair selected upon reading may be prevented by maintaining the information storage nodes 53 and 54 both at the ground potential. In addition, it is to be noted that existence of this NOR logic would not spoil the data holding in the data register because in the data register selected upon writing either one of the nodes 51 and 52 rises in response to the data binary codes DI' and $\overline{DI'}$ and thus resets the node 55 to the ground potential.

In any event, even in the consecutive access cycle having an extremely short activation time of the $\overline{CAS}$, the input information is surely latched in the data register that has been decoded on the basis of the decoded information, and by merely selecting the last cycle in the consecutive access cycle excessively by at leat 20 NS that is sufficient for generating the third write control clock which takes charge of the write level assuring function, the potentials at the corresponding I/O bus pairs can be simultaneously raised as a whole on the basis of the input information stored in the respective data registers, so that not only a remarkable advantage can be realized in that the read cycle time and the write cycle time in the consecutive access cycle can be equalized, but also another surplus advantage can be obtained in that in the consecutive access cycle it is possible to mixedly provide read and write cycles.

I claim:

1.   A memory circuit comprising a plurality of bus lines, a plurality of memory cell groups provided in correspondence to the respective one of said bus lines, a data line, a plurality of transfer gates coupled between the respective bus lines and said data line, means for supplying said data line with data to be written into said memory cells, a plurality of latch circuits coupled to the respective bus lines, and means for sequentially enabling said transfer gates,  in which said data are sequentially stored in said latch circuits  through the enabled transfer gates and the stored write data are written into the memory cells via the bus line associated to the respective latch circuit.

2.   The  circuit according to claim 1, in which each of said memory cell group includes a plurality of word lines a plurality of digit lines intersecting with said word lines and a plurality of transfer gates coupled between the respective digit lines and the associated one of said bus lines.

3.   The circuit according to claim 1, further comprising means for receiving a row address strobe signal for incorporating row address information and means for receiving a column address strobe signal for incorporating column address information.

4.   The circuit  according to claim 3, in which said enabling means operates in response to the respective activation of said column strobe signal.

5.   A memory circuit comprising a plurality of memory cells arranged in a matrix of rows and columns, a first number of bus lines, row means for selecting one of said rows, a first column decoder for selecting a first number of said columns to be connected to said first number of said bus lines, a data line, a plurality of switching means coupled between said data line and said bus lines, a second column decoder for selecting one of said switching means, and a plurality of data registers provided for  the respective data lines each for operatively storing data on the associated bus line.

6.   The circuit according to claim 5, further comprising a shift register associated to said second column decoder for forcibly and sequentialy enabling said switching means.

7.   A memory circuit comprising a plurality of bus lines, a plurality of memory cell groups provided for the respective bus lines, a data line, means for supplying said data line with data to be written into said memory cells, a plurality of latch means provided for the respective bus lines for holding said data on the associated bus line, writing said data to said latch means through said bus lines and a plurality of selection means provided for the respective memory cell groups for selecting one memory cell in the associated memory cell group to supply the selected memory cell with said data written in the latch means provided for the associated bus line.

8. The circuit according to claim 8, wherein said writing means includes means for sequentially applying said data to said plurality of bus lines.

9. The circuit according to claim 8, further comprising an output amplifier and means for selectively connecting one of said bus lines to an input terminal of said output amplifier.

10. The circuit according to claim 8, in which said writing means includes a plurality of transfer gates coupled between said bus lines and said data line.

11. A memory device comprising row lines, column lines divided into a plurality of column groups, memory cells disposed at the intersections of said row lines and column lines, each of said memory cells including means responsive to the potential at the associated row line for transferring data between the memory cell and the associated column line, sense amplifiers provided for the respective column lines, means for receiving a row address strobe signal for enabling the introduction of row address data, means for receiving a column address strobe signal for enabling the introduction of column address data, means responsive to said row address data for enabling one of said row lines, bus lines provided for the respective column groups, latch circuits provided for the respective bus lines, data line, means for supplying said data line with input data, a plurality of latch means provided for the respective column groups, a plurality of means provided for the respective latch means for making the associated latch means store said input data through said data line, and control means for enabling said plurality of making means in sequence upon each reception of said column strobe signal during under the presence of said row address strobe signal.

FIG.1
PRIOR ART

0062547

|      |                                        | READ   | WRITE  |
|------|----------------------------------------|--------|--------|
| TC1  | RAS/CAS CYCLE                           | 270 ns | 270 ns |
| TC2  | CONSECUTIVE ACCESS CYCLE                | 70 ns  | 70 ns  |
| TC3  | CONSECUTIVE ACCESS TERMINATION CYCLE    | 70 ns  | 90 ns  |

FIG.2

0062547

FIG.3

FIG.4

FIG.5